# EUROPEAN PATENT SPECIFICATION

(11) **EP 0 594 006 B1**
(45) Date of publication and mention of the grant of the patent: **23.01.2002**
(21) Application number: 93116360.4
(22) Date of filing: 08.10.1993
(51) Int. Cl.: G06F 1/28, G01R 31/36

(54) **Battery-powered data processor**
Batteriebetriebener Datenprozessor
Processeur de données alimenté par batterie

(30) Priority: 13.10.1992 JP 27439892
(43) Date of publication of application: 27.04.1994
(73) Proprietor: SANYO ELECTRIC CO., LTD., Moriguchi-shi, Osaka (JP)
(72) Inventor: Kimura, Minoru, Ora-gun, Gunma (JP); Tomizaki, Akira, Shimotsuga-gun, Tochigi (JP); Imaizumi, Yasukazu, Ashikaga-shi, Tochigi (JP); Onaya, Hitoshi, Maebashi-shi, Gunma (JP); Tokugawa,Hiroaki, Ora-gun,Gunma (JP); Ishida, Masayoshi, Ora-gun, Gunma (JP); Aikawa, Mitsuru, Ora-gun, Gunma (JP)
(74) Representative: TER MEER STEINMEISTER & PARTNER GbR

(56) References cited:
- EP-A- 0 404 061
- EP-A- 0 496 537
- US-A- 4 380 726
- PATENT ABSTRACTS OF JAPAN vol. 012, no. 175 (P-707)25 May 1988 & JP-A-62 286 116 (CANON INC.) 12 December 1987

## Description

### BACKGROUND OF THE INVENTION

### 1. Field of the Invention:

This invention relates to a data processor such as for a personal computer, and more particularly to a battery-powered data processor having a suspend/resume function.

### 2. Description of the Related Art:

In compact personal computers such as a so-called note P.C., many battery-powered personal computers have been put on the market in recent years. Such a conventional data processor is generally equipped with a so-called suspend/resume function for temporarily suspending the normal operation of the processor to suppress required power consumption and for resuming the processor to the original status (the previous status).

This suspend/resume function is exemplified by the following two methods. In one method, the contents of a main memory (DRAM), a video memory (VRAM), etc. is temporarily saved in an external storage such as a hard disc while every power supply is cut off. In the other method, the contents of a main memory (DRAM), a video memory (VRAM), etc. are backed up by a battery while the minimum necessary logic circuit part is kept energized. According to the former method, the processor can be resumed to the original status if the resume function succeeds irrespective of battery charge level, but the suspend function occasionally would not work normally, depending on the application program, so that the process cannot be resumed to the original status by the resume function. Whereas the latter method is advantageous because the suspend function would be effective to all application programs.

However, in the latter method, since the main memory, the video memory and other logic circuits are backed up by the battery, all data and programs will disappear when the battery is drained in the suspend state, so that the processor cannot be resumed to the original status by the resume function.

A battery-powered data processor (battery operated computer) known from EP 496 537 A has a normal operation mode and a suspend mode for suppressing consumption of electric power. This computer comprises means for detecting battery charge level which includes an ambient temperature sensor, a battery temperature sensor, a current sensor and a voltage sensor and means for storing tables mapping those battery parameters which are determined by the different sensors to battery charge level, i.e. to the battery charge levels low, medium and full. A power manager processor reads out the corresponding battery charge level from the table based on the battery parameters obtained by the different sensors and controls means for displaying the actual battery charge level.

A battery service life indicator known from US 4,380,726 comprises a battery voltage level detector, an operation unit and a display unit. The operation unit includes a first and a second read only memory for storing battery voltage level values and corresponding service life times. The read only memories are connected to means for selectively reading out from one of said read only memories the service life time according to the detected battery voltage level stored within a memory for storing the detected battery voltage level.

A battery powered data processor known from JP-A-62-286 116 has a voltage detector to measure the voltage of a battery, a read only memory for storing a table mapping voltage information with respect to the application time, means for calculating the residual application time, i.e. the residual service time of the battery by subtracting the application time from the allowed application time which corresponds to the minimum service time of a fully charged battery, and a display for displaying the accurate residual service time of the battery.

### SUMMARY OF THE INVENTION

With the foregoing problems in view, it is an object of this invention to provide a battery-powered data processor in which during the suspending, data and programs will be protected from being lost due to the running down of a battery.

This object is achieved by the battery-powered data processor according to claim 1.

According to the present invention the battery charge level can be obtained from the detecting means in a quantified value. After it is shifted to the suspend mode, firstly a corresponding suspensible time based on the quantified value will be displayed, and thereafter the displayed time will be decreased gradually with the lapse of time. Then, when the quantified value of the battery charge level varies, the displayed value for suspensible time will be corrected to a value corresponding to a new quantified value.

### BRIEF DESCRIPTION OF THE DRAWINGS

FIG. 1 is a block diagram showing part of a data processor according to one embodiment of this invention;
FIG. 2 is a perspective view showing the entire data processor;
FIG. 3 shows one status of display on a sub LCD of FIG. 1 ;
FIG. 4 shows the contents of a ROM table of FIG 1 ;
FIG. 5 is a flow diagram showing the suspend operation of the data processor; and
FIGS. 6A through 6D show the display operation of the sub LCD.

### DETAILED DESCRIPTION

One embodiment of this invention will now be described in detail with reference to the accompanying drawings. In this embodiment, a so-called note personal computer is used as a data processor.

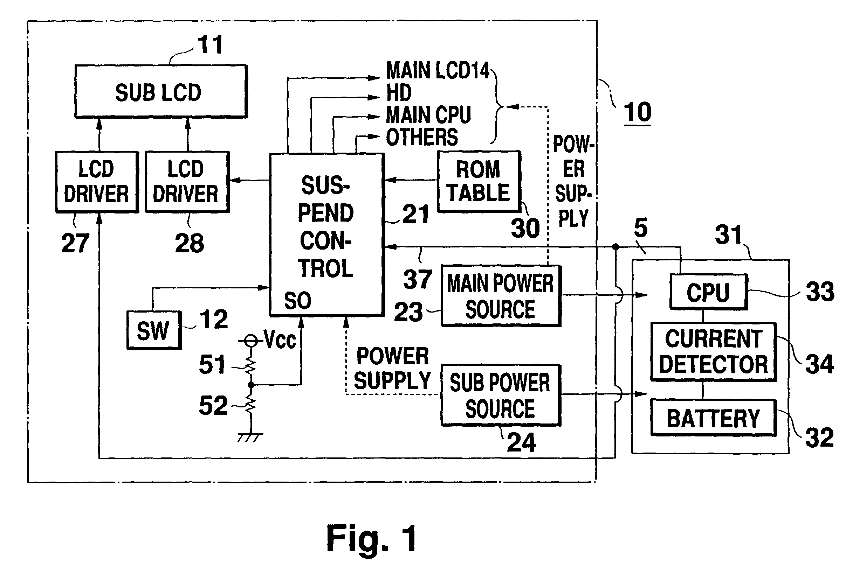

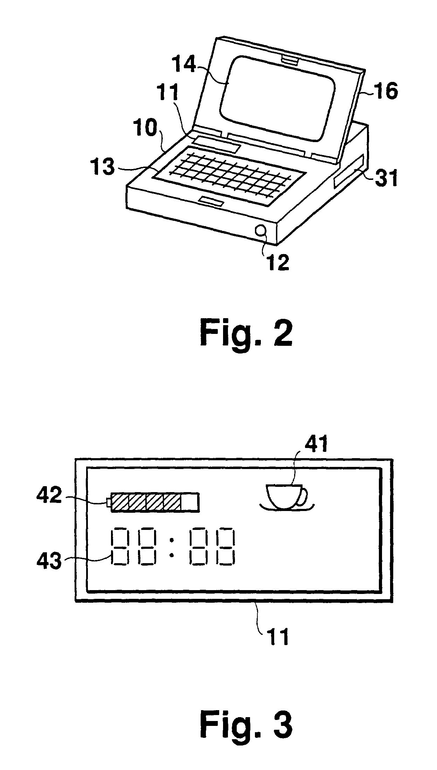

FIG. 1 shows the main part of a note personal computer of one embodiment of this invention, and FIG. 2 shows the overall appearance of the note personal computer. In FIG. 2, a push-type and momentary-type operation switch 12 is situated on a front surface of a body 10. Upon every depression of the switch 12, the normal operation mode will be inverted to the suspend mode or vice versa. A pivotable screen panel 16 has a large liquid crystal display (main LCD) 14, which displays input data from a key board 13 and data created inside the process. This data processor has a small sub LCD 11 independently of the main LCD 14; the sub LCD 11 displays predetermined system information described below. The data processor starts to operate upon receipt of a current supply from a battery pack 31 detachably mounted on the side part of the body 10.

In FIG. 1, inside the body 10 there is mounted a suspend control 21 for suppressing consumption of power for individual devices when it is in the suspend mode and controlling the sub LCD 11 via an LCD driver 28 at this time. The individual devices of the processor include the main LCD 14, a hard disc (HD), a main CPU, etc. To the suspend control 21, the operation switch 12 is connected; when the switch 12 is depressed in the normal operation mode, the suspend control 21 will make a predetermined control for shifting the normal mode to the suspend mode.

The processor is equipped with a main power source 23 and a sub power source 24 for outputting a constant d.c. voltage, with the battery pack 31 as an energy source. The sub power source 24 normally backs up the suspend control 21, irrespective of whether a non-illustrated power switch is switched on or off. The main power source 23 starts to supply the power to the remaining part of the processor when the power switch is switched on. Inside the battery pack 31, there are mounted a battery 32, a battery CPU 33 and a current detector 34. The battery CPU 33 manages the remaining amount of energy of the battery 32 in real time, based on the charging/discharging current detected by the current detector 34. From the battery pack 31, 5-bit data 37, into which the remaining amount of energy (i.e. charge level) of the battery 32 is quantified in five steps, will be given to the suspend control 21 and then will be input to the LCD driver 27.

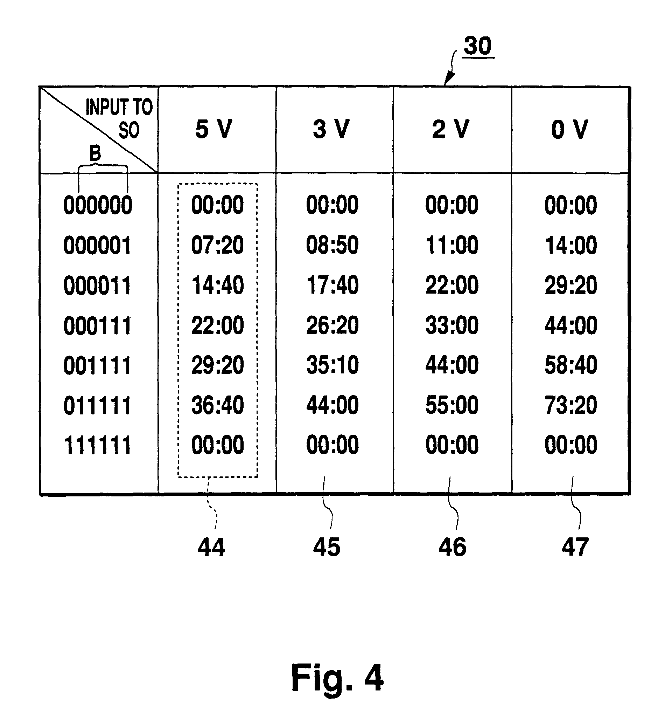

To the suspend control 21, as shown in FIG. 4, a ROM table including a plurality of tables mapping the remaining amount of energy (hereinafter called "battery charge level") of the battery pack 31 with respect to the suspensible time is connected. In the table, the most significant 1 bit of 6 bits in the left column indicates whether or not the battery pack is loaded, while the lower 5 bits indicate the battery charge level. This 5 bit value corresponds to the battery charge level data 37. The suspend control 21, as described below, creates suspensible time data to be displayed on the sub LCD 11, based on the data in this table. Alternatively the ROM table may be mounted in the suspend control 21.

The suspend control 21 has an analog input terminal SO connected to a branch point of voltage dividing resistors 51, 52 situated in series between V_{cc} and GND. By varying the values of these voltage dividing resistors 51, 52 it is possible to change the input voltage of the analog input terminal SO (e.g., between four values 5V, 3V, 2V and 0V), selecting any one of the plural tables (e.g., four tables 44 - 47) stored in the ROM table 30. For instance, if the input voltage at SO is 5 V, the table 44 will selected; if is 3V, the table 45 will be selected; and so forth. In these tables, different suspensible times are mapped with respect to the same battery charge level. The reason why plural kinds of tables are provided is that the consumption of power at the suspend mode varies sharply between different models and also that the consumption of power at the suspend mode fluctuates even between identical models. By selecting a suitable table according to the difference in consumption of power, it is possible to display a suspensible time corresponding to the respective case. During the manufacturing in particular, it is not necessary to change the ROM for every model according to the comsumption power performance, and it is also possible to change easily even after the manufacturing. In this illustrated example, an input voltage of 5V is given, and the table 44 is selected.

FIG. 3 shows the display screen, on an enlarged scale, of the sub LCD 11. On the display screen are, a suspend mode display 41 in the form of an icon, a battery charge level display 42 in the form of five rectangular icon segments, and a suspensible time display 43 in the form of seven segments for every digit. Out of these displays, the suspend mode display 41 will be displayed according to an instruction from the suspend control 21 during the suspend mode. And the suspensible time display 43 is controlled by the suspend control 21, based on the battery charge level data 37 obtained from the battery pack 31. In the normal operation mode, the current time appears on the suspensible time display 43. On the other hand, five segments constituting the battery charge level display 42 are mapped with respect to the individual bit outputs of the 5-bit battery charge level data 37; for "0" or "1" of every bit, the display will be switched on or off.

The operation of the note personal computer will now be described. When the operation switch 12 is depressed during the normal operation mode, the suspend control 21 detects this depression to control shifting the mode to the suspend mode. Specifically, the display of the main LCD 14 will be deenergized and the motor for the hard disc will be stopped and also the clock for the main CPU will be energized off and will then be held in the off state.

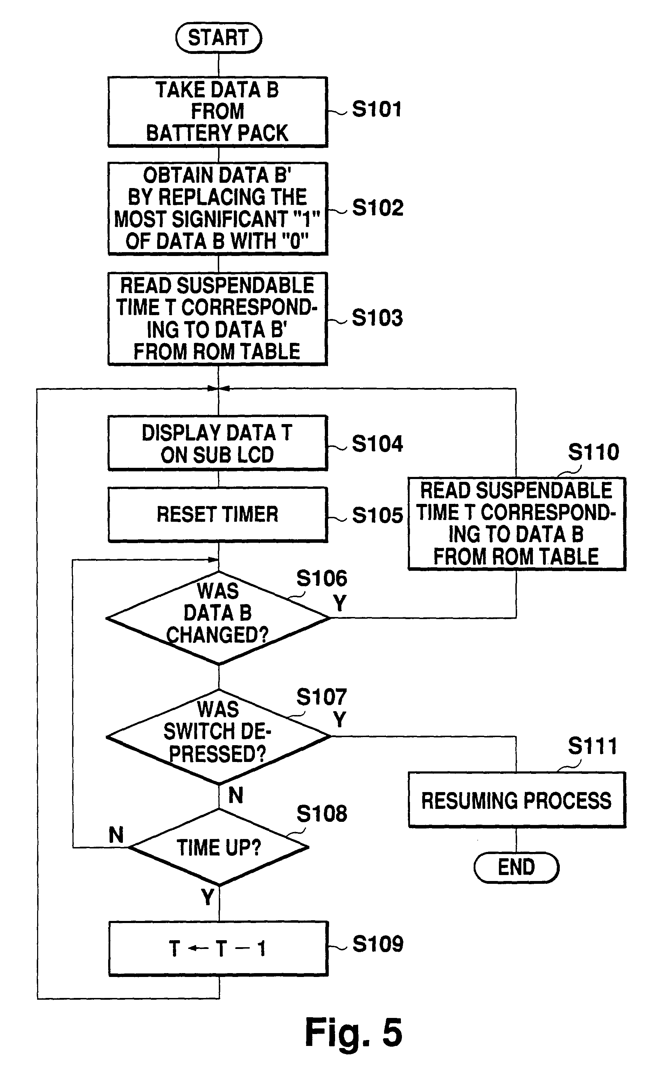

Simultaneously, the suspend control 21 starts the process as shown in FIG. 5. Specifically, 5-bit data B as battery charge level data 37 is obtained from the battery pack 31 (step S101). Then Data B' is obtained by replacing the most significant "1" contained in the data B with "0" (step S102). Referring to the table 44 of the ROM table 30, a suspensible time T corresponding to the data B' is read out (step S 103) and is then outputted to the LCD driver 28 to display it on the sub LCD 11 (step S104).

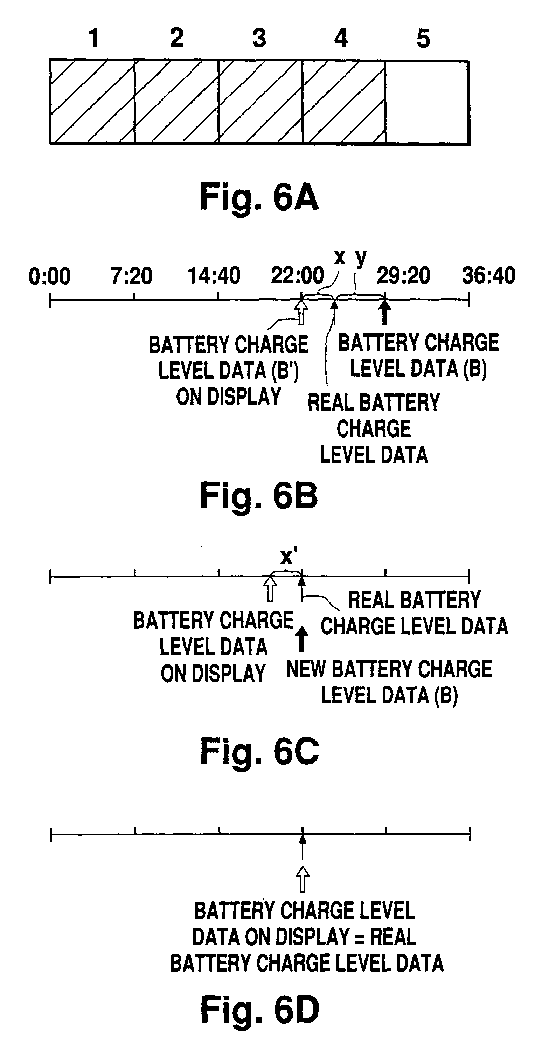

Assuming that raw data B from the battery pack 31 is "01111", the battery charge level display 42 of the sub LCD 11 will have four segments corresponding to the number of bits "1" flashing, as shown in FIG. 6A. At that time, since the data B' will be "00111", the suspensible time data T "22:00" will be read out from the corresponding table 44. As a result, the suspensible time display 43 of the sub LCD 11 will be "22:00". Therefore the user can discern that the suspend mode will continue for 22 hours.

The battery charge level data B is thus replaced with the data B' lower by one step for the following reason: For the raw data B, the battery charge level data is divided into five ranges, and the battery charge level data values within each range are quantified in a numbered step corresponding to the range. For example, assuming that raw data B is "01111", the battery charge level display 42 will have four segments flashing, as shown in FIG. 6A, while read battery charge level data is between "22:00" and "29:20" as shown in FIG. 6B. Therefore, referring to the table by using the data B directly, the display will be "29:20", which is larger by y than the actual battery charge level data. In such a case, a serious situation such as running down of the battery during the suspend mode might occur. Consequently, in this embodiment, for safety, the quantified value B' lower by one step from the quantified data B is used to display a value smaller by x from the actual battery charge level data.

In this embodiment, the battery pack 31 outputs the data B to the suspend control 21. Alternatively, the battery pack 31 may output data B', namely, a quantified value lower by one step from the step value corresponding to the existing range of the actual battery charge level data.

After the suspensible time is output and displayed at step S104, the suspend control 21 resets a non-illustrated built-in timer (step S105). If there is no change in data B (step S106; N) and the operation switch 12 is not depressed (step S107; N), the suspensible time T is decreased on the display by 1 decrement (step S109) with every lapse of a predetermined time (e.g., one minute) (step S108; Y), and the resulting suspensible time is displayed on the sub LCD 11 (step S104). As the foregoing procedures of steps S104 - S109 are repeated, the display will be decreased minute by minute. If the operation switch 12 is depressed (step S107: Y) the resuming is performed (step S111). Therefore, the display of the main LCD 14 will be turned on and the motor for the hard disc will start to operate, and at the same time, clock supply to the main CPU will be started to resume to the normal operation mode from the suspend mode.

On the other hand, at step S106, if the data B is changed to a quantified value lower by one step (step S106; Y), the data replacement as of step S102 will not take place, and therefore, the corresponding suspensible time T will be read out from the table 44 (step S110), using this new quantified value (data B), and will be displayed on the sub LCD 11 (step S104). Accordingly, as shown in FIG. 6C, the difference x' between the contents of the suspensible time display 43 and the real suspensible time will be corrected so that these two values will coincide with each other as shown in FIG. 6D.

As mentioned above, according to this invention, since the suspensible time corresponding to the battery charge level is displayed, it is possible to effectively prevent any running down of the battery during the suspend mode.

Further, since the battery charge level may be detected by a micro computer built into the battery, it is possible to obtain the accurate battery charge level.

Still further, since any one of plural kinds of tables stored in the table storing means may be selected and referred to, a suspensible time may be displayed corresponding to the actual situation or the actual value even when there is a difference and fluctuation in consumption of power between identical models, and the table can be shared between the models different in consumption of power.

Furthermore, since the suspensible time displayed on the displaying means is decreased gradually with the lapse of time, it is possible to grasp the remaining time in real time.

In addition, since the suspensible time display is corrected, the suspensible time including a safety margin may be displayed soon after shifting the mode to the suspend mode, whereupon the contents of display can be corrected accurately.

## Claims

1. A battery-powered data processor having a normal operation mode and a suspend mode for suppressing consumption of electric power, comprising:
(a) means (33, 34) for detecting the battery (32) charge level, which is capable of quantifying the battery charge level as within a predetermined numbered step and outputting a quantified value (37),
(b) means (30) for storing a table mapping battery charge level with respect to suspensible times;
(c) means (21) for reading (S103, S110) out a corresponding suspensible time from said table (30) in suspend mode based on the quantified value of the battery charge level obtained from said detecting means (33, 34); and
(d) means (11, 21, 28) for displaying (S104) the suspensible time read out by said reading means (21; S110), decreasing (S105, S108, S109) the displayed suspensible time gradually along with the lapse of time, and correcting (S106, S110) the displayed suspensible time to the suspensible time corresponding to a new quantified value when the quantified value of the battery charge level is changed to a such new quantified value.

2. A data processor according to claim 1, wherein said detecting means (33,34) includes means for measuring a charging/discharging current to from the battery (32).

3. A data processor according to claim 1, wherein said detecting means (33,34) is situated in a battery pack (31), in which the battery (32) is mounted, and includes means for measuring a charging/discharging current to from the battery (32).

4. A data processor according to claim 1, further comprising a suspend switch (12) which shifts said data processor to said suspend mode when depressed.

5. A data processor according to claim 1, wherein said storing means (30) is able to store a plurality of kinds of table (44-47) mapping different suspensible times with respect to the same battery charge level and is able to select any of the tables (44-47).

6. A data processor according to claim 1, further including a main display device (14), wherein said displaying means (11) is a dedicated display device independent of said main display device (14).

7. A data processor according to claim 1, wherein said displaying means (11) is a liquid crystal display device.

8. A data processor according to claim 1, wherein said displaying means (11) is also capable of displaying an icon (41) showing whether the present mode is the suspend mode or the normal operation mode.

9. A data processor according to claim 1, wherein said displaying means (11) is capable of displaying the suspensible time, which is read out by said reading means (21), when said data processor is in the suspend mode, and displaying a current time when said data processor is in the normal operation mode.

10. A data processor according to claim 1, further including second displaying means (11,42) for displaying battery charge level data directly corresponding to the quantified value (37) of the battery charge level obtained from said detecting means (33,34).

11. A data processor according to claim 1, wherein said reading means (21) obtains a quantified value lower by one step from the quantified value (37) of the battery charge level obtained by said detecting means (33,34) and reads out from the table (30) the suspensible time corresponding to the obtained quantified value.

12. A data processor according to claim 1, further including first displaying means (43) for displaying the suspensible time corresponding to a quantified value lower by one step from the quantified value (37) of the battery charge level obtained by said detecting means (33,34), and second displaying means (42) for displaying battery charge level data directly corresponding to the quantified value (37) of the battery charge level obtained by said detecting means (33,34).

13. A data processor according to claim 1, further comprising a sub power source (24) for normally supplying necessary operating electrical power to said reading means (21) from the battery, and a main power source (23) for supplying necessary electrical power to the components of said data processor from the battery when a main power switch is switched on.

## Patentansprüche

1. Batteriebetriebener Datenprozessor, der eine normale Betriebsart und eine Anhaltebetriebsart, in der der Verbrauch elektrischer Leistung unterdrückt wird, besitzt, mit:
(a) Mitteln (33, 34), die den Ladepegel der Batterie (32) erfassen und den Batterieladepegel als innerhalb einer vorgegebenen numerierten Stufe liegend quantifizieren können und einen quantifizierten Wert (37) ausgeben können,
(b) Mitteln (30), die eine Tabelle speichern, in der der Batterieladepegel gegenüber Anhaltezeiten eingetragen ist;
(c) Mitteln (21), die in der Anhaltebetriebsart auf der Grundlage des quantifizierten Wertes des von den Erfassungsmitteln (33. 34) erhaltenen Batterieladepegels eine entsprechende Anhaltezeit aus der Tabelle (30) auslesen (S103, S110); und
(d) Mitteln (11, 21, 28), die die von den Lesemitteln (21; S110) ausgelesene Anhaltezeit anzeigen (S104), die angezeigte Anhaltezeit mit verstreichender Zeit allmählich reduzieren (S105, S108, S109) und die angezeigte Anhaltezeit auf die Anhaltezeit korrigieren (S106, S110), die einem neuen quantifizierten Wert entspricht, wenn der quantifizierte Wert des Batterieladepegels zu einem solchen neuen quantifizierten Wert geändert wird.

2. Datenprozessor nach Anspruch 1, bei dem die Erfassungsmittel (33, 34) Mittel zum Messen eines Lade-/Entladestroms zu/von der Batterie (32) umfassen.

3. Datenprozessor nach Anspruch 1, bei dem sich die Erfassungsmittel (33, 34) in einem Batteriestapel (31), in dem die Batterie (32) angebracht ist, befinden und Mittel enthalten, die einen Lade-/Entladestrom zu/von der Batterie (32) umfassen.

4. Datenprozessor nach Anspruch 1, ferner mit einem Anhalteschalter (12), der den Datenprozessor in die Anhaltebetriebsart versetzt, wenn er gedrückt wird.

5. Datenprozessor nach Anspruch 1, bei dem die Speichermittel (30) mehrere Arten von Tabellen (40; 47) speichern können, die für denselben Batterieladepegel unterschiedliche Anhaltezeiten angeben können, und eine dieser Tabellen (44-47) auswählen können.

6. Datenprozessor nach Anspruch 1, ferner mit einer Hauptanzeigevorrichtung (14), wobei die Anzeigemittel (11) eine von der Hauptanzeigevorrichtung (14) unabhängige, spezielle Anzeigevorrichtung bilden.

7. Datenprozessor nach Anspruch 1, bei dem die Anzeigemittel (11) eine Flüssigkristall-Anzeigevorrichtung bilden.

8. Datenprozessor nach Anspruch 1, bei dem die Anzeigemittel (11) außerdem ein Icon (41) anzeigen können, das zeigt, ob die momentane Betriebsart die Anhaltebetriebsart oder die normale Betriebsart ist.

9. Datenprozessor nach Anspruch 1, bei dem die Anzeigemittel (11) die Anhaltezeit, die von den Lesemitteln (21) ausgelesen wird, wenn sich der Datenprozessor in der Anhaltebetriebsart befindet, anzeigen können und eine momentane Zeit anzeigen können, wenn sich der Datenprozessor in der normalen Betriebsart befindet.

10. Datenprozessor nach Anspruch 1, ferner mit zweiten Anzeigemitteln (11, 42), die Batterieladepegel-Daten, die dem von den Erfassungsmitteln (33, 34) erhaltenen quantifizierten Wert (37) des Batterieladepegels entsprechen, direkt anzeigen.

11. Datenprozessor nach Anspruch 1, bei dem die Lesemittel (21) aus dem quantifizierten Wert (37) des von den Erfassungsmitteln (33, 34) erhaltenen Batterieladepegels einen quantifizierten Wert, der um eine Stufe niedriger ist, erhalten und aus der Tabelle (30) die Anhaltezeit auslesen, die dem erhaltenen quantifizierten Wert entspricht.

12. Datenprozessor nach Anspruch 1, der ferner erste Anzeigemittel (43), die die Anhaltezeit anzeigen, die einem quantifizierten Wert entspricht, der um eine Stufe niedriger als der quantifizierte Wert (37) des von den Erfassungsmitteln (33, 34) erhaltenen Batterieladepegels ist, und zweite Anzeigemittel (42), die die Batterieladepegel-Daten anzeigen, die direkt dem quantifizierten Wert (37) des von den Erfassungsmitteln (33, 34) erhaltenen Batterieladepegels entsprechen, umfaßt.

13. Datenprozessor nach Anspruch 1, der ferner eine Hilfsleistungsquelle (24) für die normale Lieferung von erforderlicher elektrischer Betriebsleistung für die Lesemittel (21) von der Batterie und eine Hauptleistungsquelle (23) für die Lieferung erforderlicher elektrischer Leistung an die Komponenten des Datenprozessors von der Batterie bei geschlossenem Hauptleistungsschalter umfaßt.

## Revendications

1. Un processeur de données alimenté par batterie, ayant un mode de fonctionnement normal et un mode suspendu, pour minimiser la consommation de puissance électrique, comprenant :
(a) des moyens (33, 34) pour détecter le niveau de charge de la batterie (32), qui sont capables de quantifier le niveau de charge de la batterie, comme étant d'un niveau prédéterminé sur une échelle et en fournissant une valeur quantifiée (37) ;
(b) des moyens (30) pour stocker une table servant à cartographier le niveau de charge de la batterie, par rapport à des durées de possibilité de suspension ;
(c) des moyens (21) pour lire (S103, S110) une durée de possibilité de suspension correspondant d'après ladite table (30), en mode suspendu, en se basant sur la valeur quantifiée du niveau de charge de la batterie obtenu d'après lesdits moyens de détection (33, 34) ; et
(d) des moyens (11, 21, 28) pour afficher (S104) la durée de possibilité de suspension lue d'après lesdits moyens de lecture (21; S110), en diminuant (S105, S108, S109) la durée de possibilité de suspension affichée, graduellement, en fonction de l'écoulement du temps, et en corrigeant (S106, S110) la durée de possibilité de suspension affichée pour faire correspondre la durée de possibilité de suspension correspondant à une nouvelle valeur quantifiée, lorsque la valeur quantifiée du niveau de charge de batterie est modifiée à une telle valeur quantifiée.

2. Un processeur de données selon la revendication 1, dans lequel lesdits moyens de détection (33, 34) comprennent des moyens pour mesurer un courant de charge/décharge vers/depuis la batterie (32).

3. Un processeur de données selon la revendication 1, dans lequel lesdits moyens de détection (33, 34) sont situés dans un boîtier de batterie (31), dans lequel la batterie (32) est montée et comprennent des moyens pour mesurer un courant de charge/décharge vers/depuis la batterie (32).

4. Un processeur de données selon la revendication 1, comprenant en outre un interrupteur de suspension (12) qui fait basculer ledit processeur de données audit mode suspendu, lorsqu'on l'actionne.

5. Un processeur de données selon la revendication 1, dans lequel lesdits moyens de stockage (30) sont en mesure de stocker une pluralité de types de tables (44 à 47) servant à cartographier différents temps de suspension, eu égard au même niveau de charge de batterie et sont en mesure de sélectionner l'une quelconque des tables (44 à 47).

6. Un processeur de données selon la revendication 1, comprenant en outre un dispositif d'affichage principal (14), dans lequel lesdits moyens d'affichage (11) sont un dispositif d'affichage dédié, indépendant dudit dispositif d'affichage principal (14).

7. Un processeur de données selon la revendication 1, dans lequel lesdits moyens d'affichage (11) sont un dispositif d'affichage à cristal liquide.

8. Un processeur de données selon la revendication 1, dans lequel lesdits moyens d'affichage (11) sont également en mesure d'afficher une icône (41), représentant le fait que le présent mode de réalisation est le mode suspendu ou le mode de fonctionnement normal.

9. Un processeur de données selon la revendication 1, dans lequel lesdits moyens d'affichage (11) sont susceptibles d'afficher la durée de possibilité de suspension, lue depuis lesdits moyens de lecture (21), lorsque ledit processeur de données est en mode suspendu, et d'afficher un temps actuel lorsque ledit processeur de données est au mode de fonctionnement normal.

10. Un processeur de données selon la revendication 1, comprenant en outre des deuxièmes moyens d'affichage (11, 42) pour afficher des données de niveau de charge de batterie correspondant directement à la valeur quantifiée (37) du niveau de charge de batterie, obtenu d'après lesdits moyens de détection (33, 34).

11. Un processeur de données selon la revendication 1, dans lequel lesdits moyens de lecture (21) obtiennent une valeur quantifiée inférieure de la valeur d'un degré par rapport à la valeur quantifiée (37) du niveau de charge de batterie obtenu par lesdits moyens de détection (33, 34) et lisent depuis la table (30) la durée de possibilité de suspension correspondant à la valeur quantifiée obtenue.

12. Un processeur de données selon la revendication 1, comprenant en outre des premiers moyens d'affichage (43), devant afficher la durée de possibilité de suspension correspondant à une valeur quantifiée inférieure de la valeur d'un degré par rapport à la valeur quantifiée (37) du niveau de charge de batterie obtenu d'après lesdits moyens de détection (33, 34), et des deuxièmes moyens d'affichage (42) pour afficher des données de niveau de charge de batterie correspondant directement à la valeur quantifiée (37) du niveau de charge de batterie, obtenu par lesdits moyens de détection (33, 34).

13. Un processeur de données selon la revendication 1, comprenant en outre une source de puissance secondaire (24) devant fournir normalement la puissance électrique opérationnelle nécessaire auxdits moyens de lecture (21) depuis la batterie, et une source de puissance principale (23) pour fournir la puissance électrique nécessaire aux composants dudit processeur de données depuis la batterie, lorsqu'un interrupteur d'alimentation principale est commuté.
